# EUROPEAN PATENT APPLICATION

(11) **EP 2 854 295 A1**
(43) Date of publication of application: **01.04.2015**
(21) Application number: 12874601.3
(22) Date of filing: 18.04.2012
(51) Int. Cl.: H03K 17/16, H02M 1/38, H02M 3/155, H03K 17/08, H03K 17/687

(54) **ELECTRICAL POWER CONVERTER**

(71) Applicant: TOYOTA JIDOSHA KABUSHIKI KAISHA, Toyota-shi, Aichi-ken, 471-8571 (JP)
(72) Inventor: ISOMURA Takuya, Toyota-shi Aichi-ken, 471-8571 (JP); HAMATANI Takashi, Toyota-shi Aichi-ken, 471-8571 (JP); NAKATA Kenichi, Toyota-shi Aichi-ken, 471-8571 (JP); MATSUME Kazuya, Toyota-shi Aichi-ken, 471-8571 (JP)
(74) Representative: Kuhnen & Wacker
(86) International application number: PCT/JP2012/060399
(87) International publication number: WO 2013/157086

(57) **Abstract**

This description relates to an electrical power converter including a series connection of two transistors, and provides a technology for, if any sort of defect causes the two transistors to be turned on at the same time, suppressing increase in electrical current flowing through the transistors.

An electrical power converter disclosed herein includes a series connection of a first transistor 6a and a second transistor 6b. The electrical power converter includes a clamp circuit 5 configured to inhibit an abnormal rise in gate voltage, the clamp circuit 5 being provided in at least either the first transistor 6a or the second transistor 6b. The clamp circuit 5 includes a diode 14 and a capacitor 15. The diode 14 has an anode connected with a gate G of the transistor. The capacitor 15 has one electrode connected with a cathode of the diode 14 and the other electrode connected with an emitter E of the transistor.

## Description

### Technical Field

A technology disclosed herein relates to an electrical power converter typified by a voltage converter or an inverter.

### Background Art

A typical electrical power converter includes a series connection of two transistors. The electrical power converter converts input power into target power by adjusting on/off timing of each of the transistors and outputs target power. For example, a buck-boost converter has a set of two transistors connected with each other in series. Further, a three-phase AC output inverter includes a circuit having a parallel connection of three sets of two transistors connected with each other in series. A circuit of a series connection of two transistors has a high-voltage side connected with a high-voltage terminal of an input terminal and a low-voltage side connected with a low-voltage terminal (ground terminal). It should be noted that an electrical power converter that deals with a large amount of electrical power, such as one used in an electric vehicle, often employs IGBTs (Insulated Gate Bipolar Transistors) as the transistors.

Here, the following points concerning technical terms used herein should be noted. Three electrodes of a transistor are called "base", "collector", and "emitter" or "gate", "drain", and "source", respectively, depending on the type of transistor. For example, in the case of an FET, the three electrodes are commonly called "gate", "drain", and "source", respectively. Further, in the case of a bipolar transistor, the three electrodes may be also called "base", "collector", and "emitter", respectively. The technology disclosed herein is applicable to both a transistor whose three electrodes are called "base", "collector", and "emitter" respectively and a transistor whose three electrodes are called "gate", "drain", and "source" respectively. Accordingly, a "gate" and a "base" are collectively called "gate" herein. Similarly, a "collector" and a "drain" are collectively called "collector" herein, and an "emitter" and a "source" are collectively called "emitter" herein.

Further, in the following, for convenience of explanation, two transistors connected with each other in series are referred to as "first transistor" and "second transistor". It should be noted that the designations of "first transistor" and "second transistor" are intended to distinguish between the two transistors, and not to make any special difference between the two transistors connected with each other in series.

Now back to the description of the background art. Resistance or capacitance that is originally unintended is parasitic (accompanies), as its structural characteristics, in the transistor. A resistance parasitic on a gate electrode is called "gate resistance". A capacitance parasitic between a gate and a collector is called "feedback capacitance" (or "collector-gate capacitance"). A capacitance parasitic between a gate and an emitter is called "input capacitance" (or "gate-emitter capacitance"). These parasitic elements may give some inconveniences to a series connection circuit of transistors, and measures against these parasitic elements have been discussed.

For example, in a case where the first transistor is connected with the high-voltage side and the second transistor is connected with the low-voltage side, a collector-emitter voltage of the first transistor changes rapidly when the first transistor is turned on, an electrical current flows by the gate-collector capacitance of the second transistor. Thereby, a gate voltage of the second transistor rises. When the gate voltage exceeds a threshold voltage, the second transistor is erroneously turned on. A technology for inhibiting such a phenomenon is disclosed in Japanese Unexamined Patent Application Publication, No. 2006-324794 A (Patent Literature 1). The technology of Patent Literature 1 connects a capacitor between the gate of the first transistor and the emitter of the first transistor when the first transistor switches from being off to being on. Since the capacitor absorbs the electrical current, the change in the collector-emitter voltage generated when the first transistor was turned on can be slowed down. Thereby, the rise in the gate voltage of the second transistor is inhibited.

Further, as the first transistor is turned on/off, the gate voltage changes by an input capacitance of the second transistor. In particular, the discharge of the input capacitance causes a reduction in the gate voltage, with the result that a collector current of the second transistor decreases. A technology for inhibiting such a decrease in collector current is disclosed in Japanese Unexamined Patent Application Publication, No. 2003-125574 A (Patent Literature 2). The technology of Patent Literature 2 connects two resistors with the gate of the second transistor in series, and connects a capacitor between junction of the two resistors and the emitter of the second transistor. The charges on the newly-connected capacitor compensate for the reduction in the gate voltage caused by the discharge of the input capacitance.

This description relates to a technology for inhibiting an undesirable increase in gate voltage in an electrical power converter including a series connection of two transistors. As an example of a technology for inhibiting an undesirable increase in gate voltage, albeit not in an electrical power converter, a technology of Japanese Unexamined Patent Application Publication, No. 2003-115752 A (Patent Literature 3) is listed. The technology of Patent Literature 3 connects a zener diode between the emitter of a transistor and the gate of the transistor. The zener diode is a device configured that an electrical current flows in the reverse direction when the voltage is above a predetermined value (zener voltage/breakdown voltage). In the circuit disclosed in Patent Literature 3, the zener diode has an anode connected with the emitter and a cathode connected with the gate. When the gate voltage is above the zener voltage (breakdown voltage), the electrical current flows in the reverse direction to the zener diode, with the result that the gate voltage is maintained at the zener voltage.

### Summary of Invention

In an electrical power converter, an input voltage is supplied to a high-voltage end of a circuit having two transistors connected with each other in series, and a low-voltage end thereof is connected with the ground. Moreover, the two transistors are alternately turned on, and an electrical current is outputted from a point of connection between the two transistors to a motor. Normally, the two transistors are not simultaneously turned on. However, if the two transistors are simultaneously turned on by some sort of defect, the electrical current flowing between the emitter and the collector increases abnormally. This causes a change in the collector-emitter voltage, and the gate voltage rises. By the gate voltage rising, a vicious circle in which the collector-emitter current increases is generated. In the worst case, the collector-emitter current exceeds a withstand current threshold value, with the result that the transistors get damaged. This description provides a technology for, if the two transistors are simultaneously turned on by some sort of defect, inhibiting an increase in the electrical current flowing through the transistors.

The technology disclosed herein adds a novel clamp circuit to a circuit having two transistors connected with each other in series. Such a clamp circuit may be provided only in either of the transistors, or in both of the transistors. In a case where such a clamp circuit is provided in either of the transistors, it is preferable that the clamp circuit be provided in the lower-arm transistor. The terms "lower-arm" here means "low-voltage side". Therefore, the term "lower-arm transistor" means a transistor, of the two transistors connected with each other in series, which is located on the low-voltage side.

For convenience of explanation, the following describes a clamp circuit that is attached to the first transistor. The technology disclosed herein connects a capacitor between the gate of the first transistor and the emitter of the first transistor. Thereby, the newly-added capacitor is connected in parallel with an input capacitance that the first transistor uniquely has. When the two transistors are both turned on and an electrical current flows from the collector of the first transistor to the gate of the first transistor via a feedback capacitance, a part of the electrical current flows into the new capacitor, and the remaining part flows into the input capacitance. The rise in the gate voltage is inhibited by the newly-added capacitor absorbing a part of the emitter-gate current. In the following, such a capacitor connected between a gate and an emitter is referred to as "buffer capacitor".

Just by simply adding a buffer capacitor between a gate and an emitter, the gate voltage fluctuates by discharge and charge of the buffer capacitor when a pulse signal (PWM signal) is inputted to the gate. Accordingly, in the technology disclosed herein, a diode is inserted between the gate and the buffer capacitor. The diode has an anode connected with the gate and a cathode connected with the buffer capacitor. The diode allows an electrical current to flow from an anode to a cathode, namely, from the gate to the buffer capacitor but does not allow the electrical current to flow in the reverse direction. The insertion of the diode prevents an electrical current from flowing from the buffer capacitor to the gate, and inhibits a fluctuation in the gate voltage caused when a PWM signal is applied to the gate (a fluctuation caused by the charges on the buffer capacitor).

An aspect of the technology disclosed herein can be embodied in an electrical power converter including a series connection of a first transistor and a second transistor. The electrical power converter includes a clamp circuit configured to inhibit an abnormal rise in gate voltage, the clamp circuit being provided in at least either the first transistor or the second transistor. The clamp circuit includes a diode and a capacitor (buffer capacitor). Taking the first transistor as an example, the diode has an anode connected with a gate of the first transistor. The buffer capacitor has one electrode connected with a cathode of the diode and the other electrode connected with an emitter of the first transistor. A similar clamp circuit may be provided in the second transistor. In a case where the clamp circuit is provided in the lower-arm transistor, the other electrode of the buffer capacitor may be connected with the ground, as the emitter of the transistor is connected with the ground.

A capacitance of the buffer capacitor is preferably larger than an input capacitance of the first transistor. In general, an input capacitance of a transistor is several nanofarads. In contrast, a buffer capacitor having a capacitance of approximately several microfarads is preferably attached, for example.

As an improvement to the electrical power converter disclosed herein, the electrical power converter may include a pre-charge circuit configured to pre-charge the first transistor. The pre-charge circuit charges (pre-charges) the capacitor before the first transistor is driven. And as another improvement, the electrical power converter may further include a resistor connected with the capacitor in parallel. The former makes it possible to reduce a delay in response to the first transistor on command (the first pulse of a PWM signal). The latter makes it possible to discharge the buffer capacitor after stopping the electrical power converter.

Details of the technology disclosed herein and further improvements thereto are described in an embodiment of the invention.

### Brief Description of Drawings

FIG. 1 is a block diagram of an electrical power converter.
FIG. 2 is a block diagram of an example of a clamp circuit
FIG. 3 is a graph showing an example of a temporal change in gate voltage.
FIG. 4 is a block diagram of a clamp circuit of a first modification.
FIG. 5 is a block diagram of a clamp circuit of a second modification.
FIG. 6 is a block diagram of a clamp circuit of a third modification.
FIG. 7 is a graph showing an example of a temporal change in gate voltage in the third modification.

### Description of Embodiments

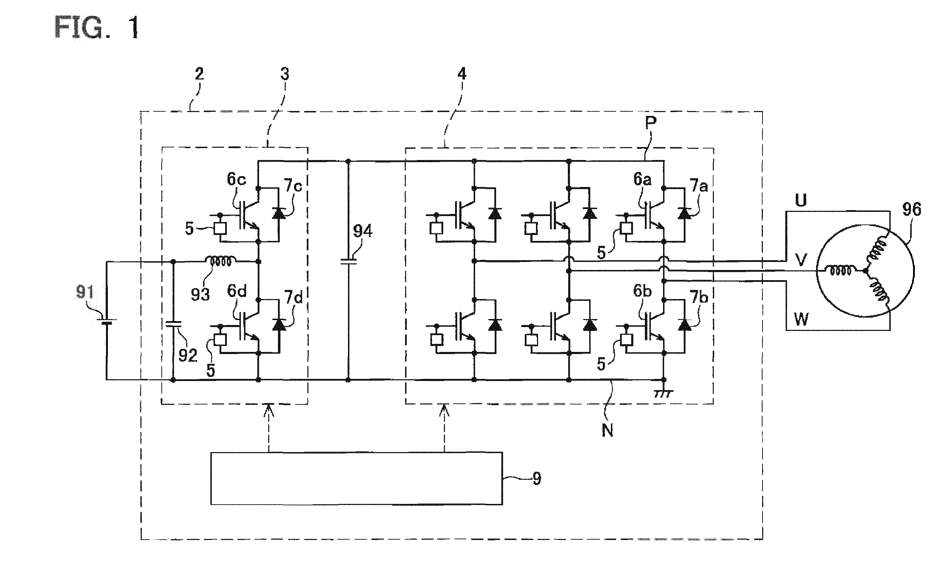

An electrical power converter of an embodiment is described with reference to the drawings. The electrical power converter of the embodiment is a device that is mounted in an electric vehicle to convert DC power of a battery into AC power that is suitable to driving of a drive motor. FIG. 1 shows a block diagram of an electrical power converter 2.

The electrical power converter 2 is constituted mainly by a buck-boost circuit 3, an inverter circuit 4, and a controller 9. The buck-boost circuit 3 has a function of raising an output voltage of a battery 91 and a function of generated electric power that is generated by a motor 96 to be as low as the output voltage of the battery 91. The buck-boost circuit 3 is constituted by a filter capacitor 92 configured to store electric power temporarily, a reactor 93, two transistors 6c and 6d, two diodes 7c and 7d, and clamp circuits 5. The two transistors 6c and 6d are IGBTs (Insulated Gate Bipolar Transistors), and are connected with each other in series. The diodes 7c and 7d are connected with the transistors 6c and 6d in inverse parallel, respectively. The diodes 7c and 7d are provided to release surge currents that are generated when the transistors are turned on, and are called "freewheel diodes". The buck-boost circuit 3 raises the battery voltage or lowers regenerated electric power by applying an appropriate PWM signal to the gates of the transistors 6c and 6d. The PWM signal is generated by the controller 9 and applied to each of the transistors. The transistors 6c and 6d used in the buck-boost circuit 3 and transistors (to be described later) used in the inverter circuit 4 are all IGBTs.

The clamp circuits 5 are connected between the gate of the transistor 6c and the emitter of the transistor 6c and between the gate of the transistor 6d and the emitter of the transistor 6d, respectively. The configurations of the buck-boost circuit 3 excluding the clamp circuits 5 are well known, and as such, are not described in detail here. The clamp circuits 5 will be described in detail later.

In driving the motor 96, the buck-boost circuit 3 raises the voltage of the battery 91 to a voltage that is suitable to motor driving. In the case of an electric vehicle, the output voltage of the battery 91 is for example 300 volts, and the voltage that is suitable to motor driving, i.e. the output voltage of the buck-boost circuit 3, is for example 600 volts.

A smoothing capacitor 94 is connected between the buck-boost circuit 3 and the inverter circuit 4. The smoothing capacitor 94 is provided to inhibit the pulsation of an electric current that is supplied to the inverter circuit 4.

The inverter circuit 4 of the present embodiment is a device for driving the three-phase AC motor 96. The inverter circuit 4 converts DC power of the battery 91 into AC power of a desired frequency. The inverter circuit 4 includes three sets of two transistors connected with each other in series. Of these three sets, a set constituted by an upper-arm transistor 6a and a lower-arm transistor 6b is described below. The same applies to the other sets. Further, for simplification of expression, the upper-arm transistor 6a and the lower-arm transistor 6b are hereinafter referred to as "upper transistor 6a" and "lower transistor 6b", respectively.

The freewheel diodes 7a and 7b connect with the upper transistor 6a and the lower transistor 6b in inverse parallel, respectively. The upper transistor 6a and the diode 7a, which are on the side of a positive electrode line P leading to the positive electrode of the battery 91, are sometimes called "upper arm", and the lower transistor 6b and the diode 7b, which are on the side of a negative electrode line N leading to the negative electrode (ground) of the battery 91, are sometimes called "lower arm". A clamp circuit 5 is connected between the gate of the upper transistor 6a and the emitter of the upper transistor 6a, and another clamp circuit 5 is connected between the gate of the lower transistor 6b and the emitter of the lower transistor 6b.

During conversion of DC power of the battery 91 into AC power and during conversion of AC power generated by the motor 96 into DC power, the upper transistor 6a and the lower transistor 6b are alternately turned on (alternately turned off). In a case where the system is normal, the two transistors are not turned on at the same time. However, in a case where there is a failure in either of the transistors, for example, the two transistors can be turned on at the same time. If the two transistors connected with each other in series are turned on at the same time, the positive electrode line P, which is at 600 volts, and the ground line N are directly connected with each other via a low resistance (on resistance between the collector and the emitter). Therefore, a large current flows through the two transistors. When the large current flows between the collector and the emitter, the gate voltage rises by parasitic elements (a feedback capacitance and an input capacitance). When the gate voltage rises, the on resistance further lowers, with the result that the collector-emitter current further increases. The clamp circuits 5 inhibit the rise in the gate voltage and prevent the collector-emitter current from increasing. Next, the clamp circuits 5 are described in detail.

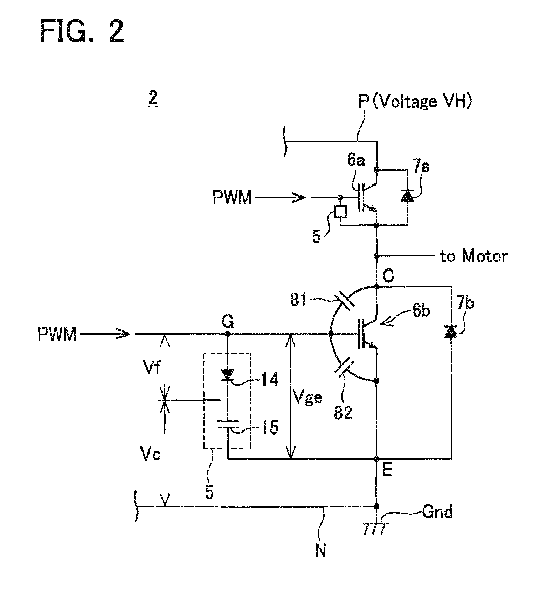

FIG. 2 shows a block diagram of a clamp circuit 5. FIG. 2 shows a block diagram of the clamp circuit 5 provided in the lower transistor 6b. FIG. 2 omits to illustrate the clamp circuit 5 provided in the upper transistor 6a. The clamp circuit 5 of the upper transistor 6a and the clamp circuit 5 of the lower transistor 6b are identical in configuration with each other.

The clamp circuit 5 is constituted by a series connection of a diode 14 and a capacitor (buffer capacitor 15). It should be noted that the name "buffer capacitor" is a designation of convenience for distinction from other capacitors (e.g. the capacitor 92 and the capacitor 94).

The diode 14 has an anode connected with a gate G of the lower transistor 6b. The buffer capacitor 15 has one electrode connected with a cathode of the diode 14 and the other electrode connected with an emitter of the lower transistor 6b. This clamp circuit 5 inhibits an excessive rise in a gate voltage Vge caused when the upper transistor 6a (upper-arm transistor) fails by short-circuiting and further the lower transistor 6b is turned on so that the positive electrode line P and the ground line N are directly connected with each other. This mechanism is herein described. It should be noted that FIG. 2 also shows a feedback capacitance 81 and an input capacitance 82, which are parasitic elements of the lower transistor 6b. The feedback capacitance 81 is a capacitor that is formed between the gate G and a collector C, and the input capacitance 82 is a capacitor that is formed between the gate G and the emitter E. They are both not designed capacitors but elements that are unavoidably formed due to the structure of the transistor.

When the upper transistor 6a fails by short-circuiting while the lower transistor 6b is on, the collector voltage of the lower transistor 6b increases and becomes substantially equal to a voltage (voltage VH) of the positive electrode line P. Due to this voltage change, an electrical current flows to the gate via the feedback capacitance 81. If there is no clamp circuit 5, the gate voltage Vge would rise. With the clamp circuit 5 added, a part of the electrical current having flowed to the gate is stored in the input capacitance 82 and the remaining part flows to the buffer capacitor 15 via the diode 14. Since the input capacitance 82 and the buffer capacitor 15 are connected with each other in parallel, the electrical charges having flowed to the gate G are dispersed to the input capacitance 82 and the buffer capacitor 15, with the result that the rise in the gate voltage Vge is inhibited. By inhibiting the gate voltage Vge, it is possible to inhibit an increase in an electrical current that flows between the collector of the lower transistor 6b and the emitter of the lower transistor 6b in a case where the upper transistor 6a fails by short-circuiting.

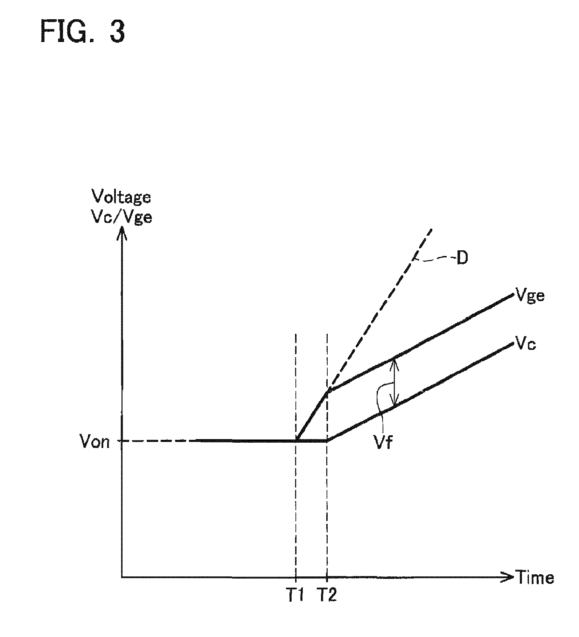

The voltage change in the gate voltage Vge of the lower transistor 6b in this time is described with reference to FIG. 3. In FIG. 3, the vertical axis represents the gate voltage Vge and the capacitor voltage Vc, and the horizontal axis represents time. Suppose the transistors 6a and 6b both are short-circuit at a time T1 in FIG. 3. To be precise, at the time T1, the upper transistor 6a is short-circuits and the lower transistor 6b is on. At the time T1, the gate voltage Vge starts to rise. At a time T2, the buffer capacitor 15 starts to be charged. Then, the voltage Vc of the buffer capacitor 15 rises, and the speed of the rise in the gate voltage Vge lowers. A dotted line D in FIG. 3 indicates a temporal change in the gate voltage Vge at the time of a short circuit in the absence of the clamp circuit 5. As shown in FIG. 3, the clamp circuit 5 inhibits the rise in the gate voltage Vge. It should be noted that the difference between the voltage Vc of the buffer capacitor 15 and the gate voltage Vge corresponds to an on voltage Vf that is unique to the diode 14.

As mentioned above, the clamp circuit 5 inhibits the rise in the gate voltage Vge by charging the buffer capacitor 15 with a part of the electrical current flowing to the gate G via the feedback capacitance 81. Therefore, the larger a capacitance of the buffer capacitor 15 is, the better it is. The input capacitance is approximately several nanofarads. It is preferable that the capacitance of the buffer capacitor 15 be approximately several microfarads, which is larger than the input capacitance by several digits. In other words, it is preferable that the capacitance of the buffer capacitor 15 be larger than the input capacitance. It should be noted that it is desirable that the capacitance of the buffer capacitor 15 be selected so that the voltage fully charged exceeds the ON voltage (High level voltage of a pulse of a PWM signal) of the gate. The performance (gate voltage inhibition performance) of the clamp circuit 5 is determined by a margin of capacitance that corresponds to the difference between the voltage fully charged and the ON voltage.

The diode 14 is inserted to prevent the electrical charges on the buffer capacitor 15 from flowing in the reverse direction to the gate G. In the absence of the diode 14, the gate voltage fluctuates when a PWM signal is applied to the gate of the lower transistor 6b, with the result that switching responsivity lowers. By the diode 14, fluctuation of the gate voltage is inhibited when a PWM signal is applied to the gate of the lower transistor 6b.

The advantages of the clamp circuit 5 as compared with a zener diode are explained here. The clamp circuit 5 inhibits an excessive rise in gate voltage. In other words, the clamp circuit 5 clamps the gate voltage. A gate voltage can also be inhibited by using a zener diode. However, there is a disadvantage to a clamp circuit using a zener diode. The zener diode is a device that permits an electrical current to flow in the reverse direction when the voltage is above a breakdown voltage. When the zener diode is used, an anode of the zener diode is connected with an emitter of a transistor and a cathode of the zener diode is connected with a gate of the transistor. When the gate voltage is above the breakdown voltage (zener voltage), an electrical current flows from the cathode to the anode, with the result that the gate voltage is held at the zener voltage. By using the zener diode, the electrical current has continued flowing from the gate to the collector, overheating in other devices or elements may be invited. As shown in the present embodiment, to constitute the clamp circuit by the diode and the capacitor, excess electrical charges on the gate is charged into the capacitor, the electrical current does not flow to the emitter. Therefore, the clamp circuit 5 of the embodiment is unlikely to invite overheating in other devices or elements.

Further, the zener diode has its anode connected with the emitter of the transistor and its cathode connected with the gate of the transistor. This brings about a disadvantage of an electrical current flowing from the emitter to the gate. This disadvantage causes the gate voltage to fluctuate when a PWM signal is applied to the gate. The clamp circuit 5 of FIG. 2 does not have such a disadvantage.

Furthermore, since the capacitor (buffer capacitor) is charged only while the gate of the transistor is on, there is advantage that a loss is smaller than the zener diode where a loss occurs during conduction. For example, in a case where a capacitor having a capacitance C = 0.33 [µF] is charged with an applied voltage V = 15 [V], the loss Ec = 1/2 x C x V² = 37 [µJ]. On the other hand, in a case where a zener diode is used, the loss Ed = V x It = 75 [mJ], assuming that the applied voltage V = 15 [V] and the leak current It = 5 [mA]. The loss Ec incurred when the capacitor is used is far smaller than the loss Ed incurred when the zener diode is used. It should be noted that a leak current of the diode connected with the buffer capacitor is on the order of microamperes, and such a loss is negligible.

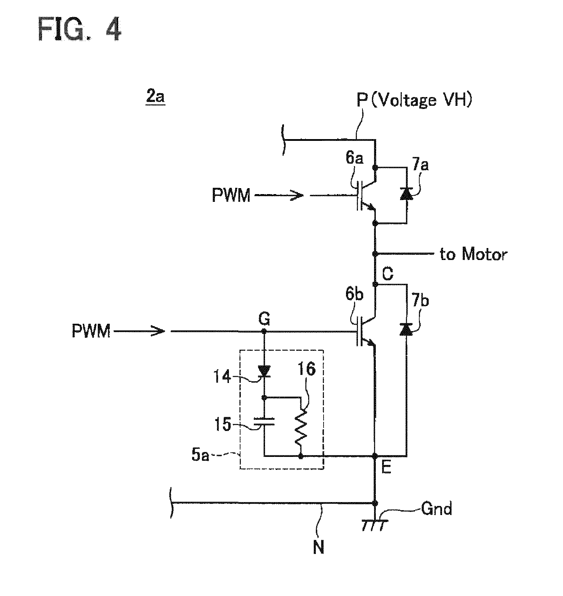

Some improvements to the clamp circuit 5 shown in FIG. 2 are herein described. FIG. 4 is a block diagram of a clamp circuit 5a of a first modification. The clamp circuit 5a is the same as the clamp circuit 5 of FIG. 2 except for a resistor 16. The resistor 16 is connected with the buffer capacitor 15 in parallel. The resistor 16 is provided for the buffer capacitor 15 to discharge after an electrical power converter 2a has stopped. The resistor 16 prevents charges from indefinitely remaining in the buffer capacitor 15.

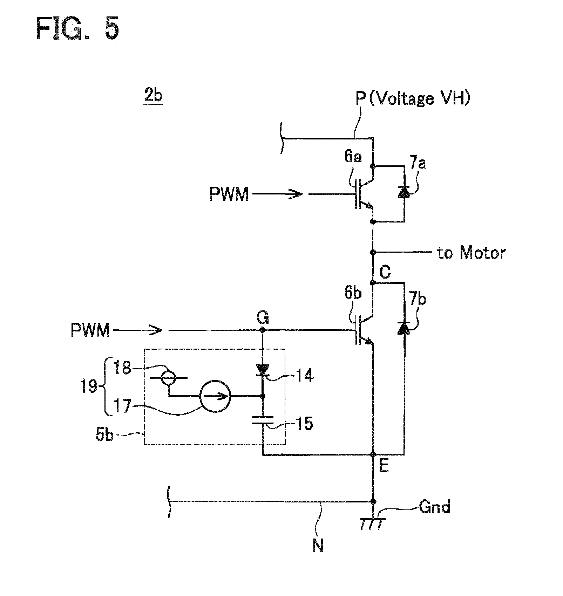

FIG. 5 shows a block diagram of a clamp circuit 5b of a second modification. The clamp circuit 5b is the same as the clamp circuit 5 of FIG. 2 except for a pull-up power supply 18 and a constant-current device 17. The constant-current device 17 may be a diode configured to allow a constant current to flow. The constant-current device 17 has an output connected between the diode 14 and the buffer capacitor 15. The pull-up power supply 18 and the constant-current device 17 constitute a pre-charge circuit 19 configured to charge the buffer capacitor 15 with a predetermined capacitance. A voltage of the pull-up power supply 18 is set to be equivalent to the ON voltage of the lower transistor 6b. With the clamp circuit 5 of FIG. 2, the capacitance of the buffer capacitor 15 is zero before an electrical power converter 2b is activated. Therefore, immediately after the electrical power converter 2b is activated, the lower transistor 6b is delayed in switching operation until the buffer capacitor 15 is charged. The pre-charge circuit 19 pre-charges the buffer capacitor 15. Specifically, the pre-charge circuit 19 charges the buffer capacitor 15 before the lower transistor 6b is driven. By the provision of the pre-charge circuit 19, the voltage Vc of the buffer capacitor 15 becomes substantially equal to the on voltage of the gate immediately after activation of the electrical power converter 2b. That is, immediately after being activated, the electrical power converter 2b of FIG. 5 can make the voltage Vc of the buffer capacitor 15 equal to the gate voltage Vge at the time turning on as shown in FIG. 3. This makes it possible to prevent a delay in switching of the lower transistor 6b immediately after activation. It should be noted that the pull-up power supply 18 and the constant-current device 17 are selected so that a capacitance (pre-charge capacitance) that is charged by the pre-charge circuit 19 is smaller than a maximum capacitance of the buffer capacitor 15. The difference between the maximum capacitance and the pre-charge capacitance determines the gate voltage inhabitation performance.

It is also preferable that the upper-arm transistor 6a include a clamp circuit 5b including a pre-charge circuit 19. Furthermore, it is also preferable that a clamp circuit include both a resistor 16 of FIG. 4 and a pre-charge circuit 19 of FIG. 5.

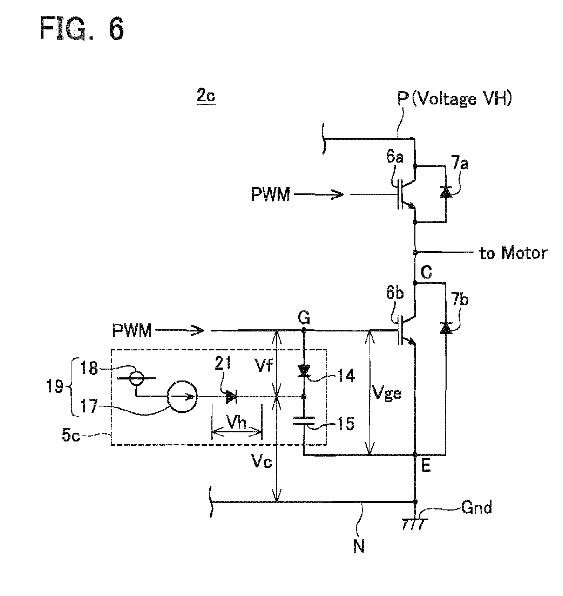

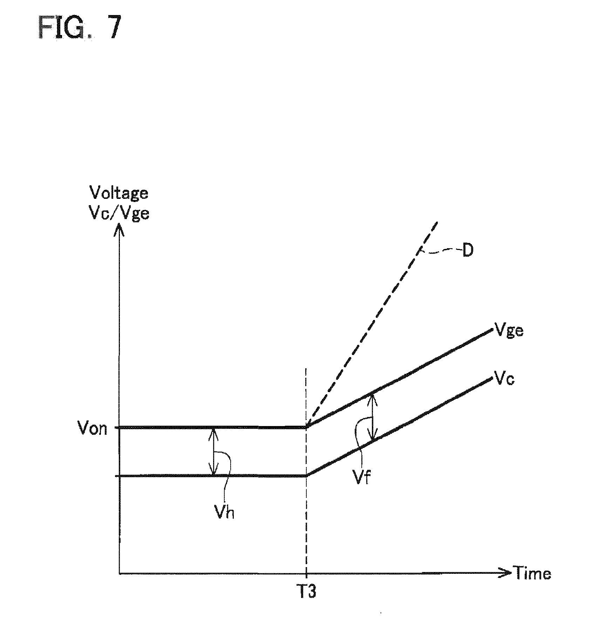

FIG. 6 shows a block diagram of a clamp circuit 5c of a third modification. The clamp circuit 5c is the same as the clamp circuit 5b of FIG. 5 except for a voltage-adjusting diode 21. The voltage-adjusting diode 21 has an anode connected with the constant-current device 17 and a cathode connected with the high-voltage side of the buffer capacitor 15. As in the case of the clamp circuit 5b of FIG. 5, a voltage of the pull-up power supply 18 is set to be the same as the on voltage of the lower transistor 6b. FIG. 7 shows a change in the gate voltage Vge as observed when the clamp circuit 5c of FIG. 6 is employed. A time T3 corresponds to timing when the upper transistor 6a is failed by short-circuiting and the lower transistor 6b is turned on. When the buffer capacitor 15 is charged with a pre-charge capacitance, the voltage Vc of the buffer capacitor 15 decreases by a voltage Vh of the voltage-adjusting diode 21. Conversely, the gate voltage Vge can be kept higher than the voltage Vc of the buffer capacitor 15 by Vh. Therefore, when the upper transistor 6a is failed by short-circuiting while the lower transistor 6a is on, an electrical current flows into the gate G from the collector C via the feedback capacitance, but the electrical current flows into the buffer capacitor 15 without delay. In the result, the rise in the gate voltage Vge is inhibited immediately after the time T3, i.e. the timing when the upper transistor 6a becomes short-circuits and the lower transistor 6b is turned on. It should be noted that in FIG. 7, too, the dotted line D indicates an increase in gate voltage in the absence of a clamp circuit.

Here are points to be kept in mind concerning the technology described in the embodiment. In the embodiment, a clamp circuit provided in the lower transistor 6b (lower-arm transistor) has been described. The same clamp circuit can also be applied to the upper transistor 6a (upper-arm transistor). Further, the same clamp circuit can also be applied to the transistors 6c and 6d of a buck-boost. Therefore, the first transistor may be an upper transistor or a lower transistor, and the second transistor may also be an upper transistor or a lower transistor. It should be noted that the names "first transistor" and "second transistor" are merely designations of convenience for distinction between the two transistors connected with each other in series.

The technology disclosed herein can be applied not only to IGBTs but also to other types of transistor such as FETs. In general, electrodes of an FET are called "gate", "drain", and "source", respectively. On the other hand, a "gate" and a "base" are collectively called "gate" herein. Similarly, a "collector" and a "drain" are collectively called "collector" herein, and an "emitter "and a "source" are collectively called "emitter" herein. Therefore, in a case where the technology disclosed herein is applied to other types of transistor, the terms "gate", "collector", and "emitter" in the claims can mean "base", "drain", and "source", respectively.

Representative, non-limiting examples of the present invention have been described in further detail with reference to the attached drawings. This detailed description is merely intended to teach a person of skill in the art further details for practicing preferred aspects of the present inventions and is not intended to limit the scope of the invention. Furthermore, each of the additional features and inventions disclosed above may be utilized separately or in conjunction with other features and inventions to provide improved an electrical power converter.

Moreover, combinations of features and steps disclosed in the above detail description may not be necessary to practice the invention in the broadest sense, and are instead taught merely to particularly describe representative examples of the invention. Furthermore, various features of the above-described representative examples, as well as the various independent and dependent claims, may be combined in ways that are not specifically and explicitly enumerated in order to provide additional useful embodiments of the present inventions.

All features disclosed in the description and/or the claims are intended to be disclosed separately and independently from each other for the purpose of original written disclosure, as well as for the purpose of restricting the claimed subject matter, independent of the compositions of the features in the embodiments and/or the claims. In addition, all value ranges or indications of groups of entities are intended to disclose every possible intermediate value or intermediate entity for the purpose of original written disclosure, as well as for the purpose of restricting the claimed subject matter.

Specific examples of the present invention has been described in detail, however, these are mere exemplary indications and thus do not limit the scope of the claims. The art described in the claims include modifications and variations of the specific examples presented above. Technical features described in the description and the drawings may technically be useful alone or in various combinations, and are not limited to the combinations as originally claimed. Further, the art described in the description and the drawings may concurrently achieve a plurality of aims, and technical significance thereof resides in achieving any one of such aims.

## Claims

1. An electrical power converter including a series connection of a first transistor and a second transistor, the electrical power converter comprising:
a diode having an anode connected with a gate of the first transistor; and
a capacitor having one electrode connected with a cathode of the diode and the other electrode connected with an emitter of the first transistor.

2. The electrical power converter according to claim 1, wherein a capacitance of the capacitor is larger than an input capacitance caused between the gate of the first transistor and the emitter of the first transistor.

3. The electrical power converter according to claim 1 or 2, further comprising:
a pre-charge circuit configured to pre-charge the capacitor.

4. The electrical power converter according to any one of claims 1 to 3, further comprising;
a resistor connected with the capacitor in parallel.
